# EUROPÄISCHE PATENTSCHRIFT

(11) **EP 2 063 533 B1**
(45) Veröffentlichungstag und Bekanntmachung des Hinweises auf die Patenterteilung: **18.04.2012**
(21) Anmeldenummer: 08019650.4
(22) Anmeldetag: 11.11.2008
(51) Int. Cl.: H03K 17/96

(54) **Bedienvorrichtung mit wenigstens einem Druckschalter**
Operating device with at least one pressure switch
Dispositif de commande doté d'au moins un interrupteur à pression

(30) Priorität: 16.11.2007 DE 102007054778
(43) Veröffentlichungstag der Anmeldung: 27.05.2009
(73) Patentinhaber: Diehl AKO Stiftung & Co. KG, 88239 Wangen (DE)
(72) Erfinder: Heimann, Uwe, 88239 Wangen (DE); Koch, Klaus-Peter, 88250 Weingarten (DE); Prinz, Michael, 88299 Leutkirch (DE)
(74) Vertreter: Diehl Patentabteilung

(56) Entgegenhaltungen:
- EP-A1- 1 780 159
- WO-A1-96/20533
- DE-A1- 4 332 927
- US-A- 4 618 797
- US-B1- 6 310 428

## Beschreibung

Die vorliegende Erfindung betrifft eine Bedienvorrichtung mit wenigstens einem Druckschalter, wie sie beispielsweise in einer Bedienblende für ein elektronisches Haushaltsgerät eingesetzt werden kann.

Es sind Drucktastschalter bekannt, welche den Piezoeffekt ausnutzen. Solche Drucktastschalter enthalten ein piezoelektrisches Element, das zwischen zwei Elektroden angeordnet ist. Beim Ausüben eines Drucks bzw. einer Kraft auf das piezoelektrische Element wird an den beiden Elektroden eine Ladung freigesetzt, die proportional zur ausgeübten Kraft ist. Über die Messung dieser Ladung kann so eine Betätigung des Drucktastschalters festgestellt werden, wobei der notwendige Betätigungsweg sehr gering ist.

Die Verwendung derartiger Drucktastschalter mit piezoelektrischem Element hat einige Vorteile im Vergleich zu herkömmlichen Tastschaltern. Aufgrund der minimalen Betätigungswege entsteht kein Verschleiß von mechanisch beweglichen Teilen und ist ein einfacher und mechanisch robuster Aufbau des Tastschalters möglich. Weiter sind in den zugehörigen Bedienblenden zum Beispiel der elektronischen Haushaltsgeräte keine Durchbrüche oder Erhebungen bzw. Vertiefungen notwendig, weshalb der Drucktastschalter feuchtigkeitsdicht angeordnet ist und die Bedienblende einfach gereinigt werden kann.

Als piezoelektrisches Element für einen solchen Drucktastschalter ist es aus dem Stand der Technik bekannt, zum Beispiel eine so genannte Piezofolie einzusetzen. Bei einer Piezofolie wird auf einer Kunststofffolie in mehreren Schritten zum Beispiel im Siebdruck ein piezoelektrischer Schichtaufbau hergestellt, wobei die Piezokristalle beispielsweise in Form eines Piezolackes aufgedruckt werden. Die Elektroden, über welche die von den Piezokristallen erzeugte elektrische Ladung abgegriffen wird, werden dabei zwischen den Schichten des Mehrschichtaufbaus zum Beispiel durch Aufdrucken angeordnet.

Bei elektronischen Haushaltsgeräten und dergleichen besteht Bedarf an einer sehr kompakten und montagefreundlichen Bedienvorrichtung, die außerdem einen möglichst hohen Integrationsgrad besitzen soll.

Die US 4,618,797 A offenbart eine Bedienvorrichtung mit einem Drucktastschalter, welche ein Trägerelement, eine mit dem Trägerelement über eine klebeschicht verbundene Piezofolie, ein im Bereich des Sensorfeldes auf die Piezofolie geklebtes Abstandselement und eine auf das Abstandselement und einen Blendenkörper geklebte Deckschicht aufweist.

Die WO 96/20533 A1 offenbart eine Bedienvorrichtung mit mehreren Sensorbereichen, welche eine Trägerelement, einem mit dem Trägerelement über eine klebeschicht verbunderen EMF-Film und eine mit der EMF-Komponente über eine klebeschicht verbundene Deckplatte aufweist.

Die EP 1 780 159 A1 offenbart eine Bedienvorrichtung für einen Aufzug mit wenigstens einem drucksensitiven Aktionsfeld, welche eine Grundplatte, eine mit der Grundplatte über klebefolie verbundenes Piezoelement und ein mit dem Piezoelement über eine weitere klebefolie verbundenes Druckelement aufweist, wobei das Druckelement das Aktionsfeld definiert und in eine Deckplatte eingesetzt ist.

Der vorliegenden Erfindung liegt ,daher die Aufgabe zugrunde, eine verbesserte Bedienvorrichtung mit wenigstens einem Drücktastschatter vorzusehen, die eine gute thermische Funktionsstabilität besitzt.

Diese Ausgabe wird gelöst-durch eine Bedienvorrichtung mit den Merkmalen des Anspruchs 1. Vorteilhafte Ausgestaltungen und Weiterbildungen der Erfindung sind Gegenstand der abhängigen Ansprüche.

Die Bedienvorrichtung mit wenigstens einem Drucktastschalter gemäß der Erfindung weist ein Trägerelement; eine Piezofolie mit wenigstens einem Sensorfeld entsprechend dem wenigstens einen Drücktastschatter, wobei die Piezofolie mit dem Trägerelement über eine erste Klebeschicht verbunden ist; eine der Benutzerseite zugewandte Deckschicht, die über eine zweite Klebeschicht mit der Piezofolie verbunden ist; und wenigstens ein Befestigungselement zum Befestigen der Bedienvorrichtung an einer Bedienblende auf.

Der Aufbau dieser Bedienvorrichtung mit Trägerelement, Piezofolie und Deckschicht stellt-eine sehr flache Bauweise dar. Die Bedienvorrichtung dieses Aufbaus kann vorgefertigt werden und so auf einfache Weise als eine Baueinheit zum Beispiel in einer Bedienblende eines elektronischen Haushaltsgeräts montiert werden. Die Bedienvorrichtung enthält dabei vorzugsweise eine Vielzahl von auf dem Piezoeffekt beruhenden Drucktastschaltem.

In einer Ausgestaltung der Erfindung weist das Trägerelement auf seiner der Piezofolie abgewandten Seite eine Aussparung auf und die Bedienvorrichtung ist ferner mit einer Leiterplatte versehen, die in die Aussparung des Trägerelements eingesetzt ist, vorzugsweise darin im Wesentlichen vollständig aufgenommen ist. Hierdurch ist eine extrem flache Konstruktion der Bedienvorrichtung einschließlich Leiterplatte ermöglicht.

Gemäß der erfindung ist die zweite Klebeschicht zwischen der Piezofolie und der Deckschicht weich ausgebildet und zwischen der Piezofolie und der Deckschicht ist im Bereich des wenigstens einen Sensorfeldes innerhalb eines von der zweiten Klebeschicht ausgesparten Raums ein Kraftübedragungselement zum Beispiel in Form eines mit der Deckschicht verbundenen Stößels angeordnet.

Die Übertragung des von einem Finger auf die Deckschicht der Bedienvorrichtung aufgebrachten Drucks auf die Piezofolie erfordert eigentlich eine steife und unnachgiebige Flächenverbindung zwischen diesen beiden Elementen. Aufgrund der im Allgemeinen unterschiedlichen Wärmeausdehnungskoeffizienten der für diese Elemente verwendeten Materialien kann es aber zu einer wärmeabhängigen Verspannung bzw. Verformung und unter Umstanden sogar zu einer Beschädigung des konstruktive Aufbaus kommen. Bei der Verwendung einer weichen bzw. nachgiebigen Flächenverbindung zwischen der Piezofolie und der Deckschicht durch die zweite Klebeschicht können die unterschiedlichen Wärmeausdehnungen der miteinander verbundenen Komponenten kompensiert bzw. vermindert werden. Um trotz dieser weichen Flächenverbindung die kleinen Betätigungswege von der Deckschicht auf die Piezofolie übertragen zu können, ist zwischen den beiden Elementen ein geeignetes Kraftübertragungselement vorgesehen, das in einer Aussparung der zweiten Klebeschicht angeordnet ist. Dieses Kraftubertragungselement stellt trotz der weichen Flächenverbindung die für eine einwandfreie Funktion erforderliche unnachgiebige Kopplung zwischen der Deckschicht und der Sensorfolie her.

In einer weiteren Ausgestaltung der Erfindung kann das wenigstens eine Befestigungselement eine dritte Klebeschicht und/oder eine Rastvorrichtung enthalten.

In einer noch weiteren Ausgestaltung der Erfindung weist die Bedienvorrichtung ferner wenigstens ein Anzeigeelement (Leuchtdiode, Display) auf, das ebenfalls in kompakter und flacher Bauweise in dem Trägerelement integriert ist.

Die oben beschriebene Bedienvorrichtung der Erfindung ist in besonders vorteilhafter Weise in einer Bedienblende für ein elektronisches Haushaltsgerät einsetzbar, ohne dass die Erfindung auf diese Anwendung beschränkt sein soll.

Obige sowie weitere Merkmale und Vorteile der Erfindung werden aus der nachfolgenden Beschreibung bevorzugter, nicht-einschränkender Ausführungsbeispiele unter Bezug auf die beiliegenden Zeichnungen besser verständlich. Darin zeigen:
- Fig. 1: eine schematische Perspektivansicht einer in eine Bedienblende ein- gesetzten Bedienvorrichtung der Erfindung;
- Fig. 2: eine perspektivische Explosionsdarstellung des Grundanfbaus einer Bedienvorrichtung gemäß der Erfindung
- Fig. 3: eine schematische Teilschnittansicht der Bedienvorrichtung von Fig. 2 im montierten Zustand;
- Fig. 4: eine schematische Teilschnittansicht der Bedienvorrichtung von Fig. 2 im montierten Zustand;
- Fig. 5: eine perspektivische Explosionsdarstellung einer Bedienvorrichtung gemäß einem Ausführungsbeispiel; und
- Fig. 6: eine schematische Teilschnittansicht der Bedienvorrichtung von Fig. 5.

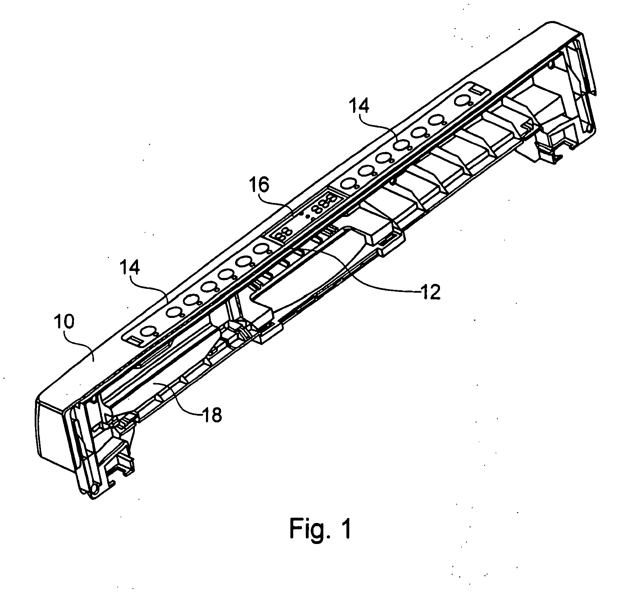

Fig. 1 zeigt beispielhaft eine Bedienblende 10 für ein elektronisches Haushaltsgerät (zum Beispiel Herd, Kochfeld, Waschmaschine, Trockner, Spülmaschine, usw.), ohne dass die Erfindung auf diese Anwendung beschränkt sein soll.

Auf der dem Benutzer zugewandten Seite (oben in Fig. 1) hat die Bedienblende 10 eine Aussparung, in welche eine Bedienvorrichtung (bzw. Bedien- und Anzeigevorrichtung oder Eingabe/Ausgabe-Vorrichtung) 12 eingesetzt ist, welche zwei Eingabebereiche 14 mit jeweils mehreren Drucktastschaltern und einen zentralen Anzeigebereich 16 aufweist. In Fig. 1 ist außerdem eine elektronische Steuerung 18 des Haushaltsgeräts erkennbar, welche mit der Bedienvorrichtung 12 über ein entsprechendes Verbindungskabel (nicht dargestellt) verbunden ist.

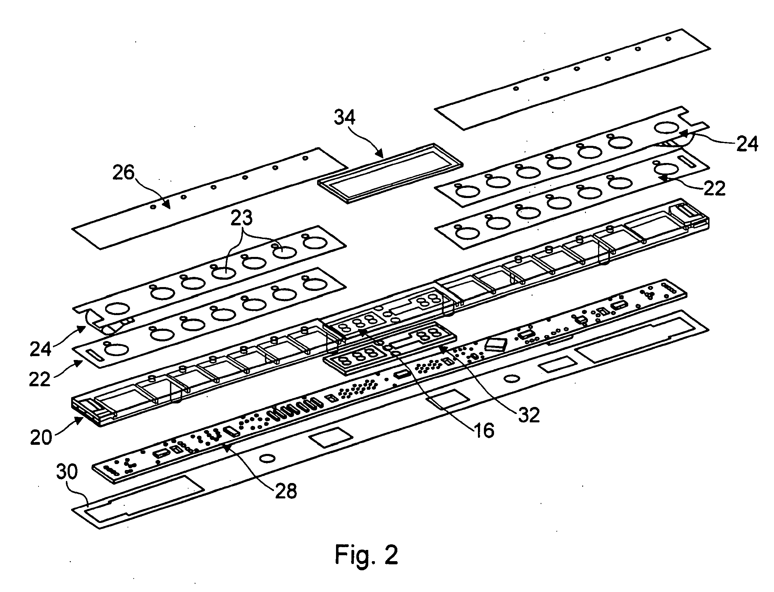

Es wird nun Bezug nehmend auf Fig. 2 bis 4 ein Grundaufbau einer erfindungsgemäßen Bedienvorrichtung 12 näher beschrieben.

Die Bedienvorrichtung 12 enthält ein Trägerelement 20 zum Beispiel aus Kunststoff (z.B. PMMA), dessen Maße im Wesentlichen die Größe der Bedienvorrichtung 12 bestimmen. Auf der dem Benutzer zugewandten Seite (oben in Fig. 2) des Trägerelements 20 sind in den beiden Eingabebereichen 14 der Bedienvorrichtung 12 zwei Piezofolien 24 angeordnet, welche über eine erste Klebeschicht 22 mit dem Trägerelement 20 verbunden sind. Die erste Klebeschicht 22 bildet üblicherweise eine nachgiebige und weiche Flächenverbindung zwischen dem Trägerelement 20 und den Piezofolien 24.

Als Piezofolien 24 können grundsätzlich beliebige Piezofolien benutzt werden; die Erfindung ist auf keine spezielle Art eingeschränkt. Bei den Piezofolien 24 handelt es sich jeweils um ein mehrschichtiges piezoelektrisches Element, das bei Ausübung eines Drucks oder einer Kraft eine an den Elektroden messbare Spannung erzeugt, wie bereits in der Beschreibungseinleitung erläutert. Die Piezofolien 24 besitzen jeweils mehrere Sensorfelder 23, die in Anzahl und Anordnung den gewünschten Drucktastschaltem der Bedienvorrichtung 12 entsprechen.

Auf der dem Benutzer zugewandten Seite (oben in Fig. 1) der Piezofolien 24 sind zwei Deckschichten 26 vorgegehen, die mit den Piezofolien 24 jeweils über eine zweite Klebeschicht (nicht dargestellt in Fig. 2) steif und unnachgiebig verbunden sind. Die Deckschichten 26 sind in der Form einer Folie zum Beispiel aus Metall gebildet und dienen einerseits als Betätigungsfläche, die vom Benutzer mit Druck beaufschlagt werden kann, um einen entsprechenden Drucktastschalter an der Position eines Sensorfeldes 23 der Piezofolie 24 zu betätigen, kennzeichnen für den Benutzer die einzelnen Drucktastschalter entsprechend den Positionen der Sensorfelder 23 der Piezofolien 24 und dienen schließlich als Designelement der Bedienblende 10.

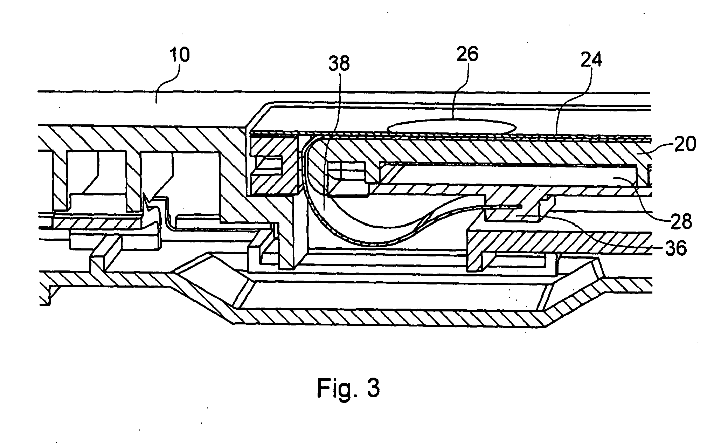

Weiter hat die Bedienvorrichtung 12 eine Leiterplatte 28 mit einer Auswerte- und Steueretektronik der Bedienvorrichtung; die in eine Aussparung an der des Benutzer abgewandten Seite (unten in Fig. 2) des Trägerelements 20 eingesetzt bzw. vorzugsweise im Wesentlichen vollständig aufgenommen ist. üblicherweise ist die Leiterplatte 28 in die entsprechende Ausnehmung des Trägerelements 20 festgeklemmt oder wahlweise auch mit Klebepunkten fixiert. Wie in Fig. 3 veranschaulicht, sind die Piezofolien 24 jeweils über ein Verbindungskabel 38 mit einem entsprechenden Anschluss / Stecker 36 auf der Leiterplattenunterseite verbunden. Die Leiterplatte 28 ist wiederum über ein entsprechendes Verbindungskabel mit der elektronischen Steuerung 18 verbunden, obwohl dies in den Figuren nicht dargestellt ist.

Durch den oben beschriebenen Schichtaufbau der Bedienvorrichtung einschließlich Piezofolien 24 und Leiterplatte 28 steht eine Bedienvorrichtung mit einer extrem flachen Konstruktion und einem hohem Integrationsgrad zur Verfügung. Die Bedienvorrichtung 12 mit einer Vielzahl von Drucktastschaltem kann als eine Baueinheit vormontiert und dann in die Bedienblende 10 eingesetzt werden, was die Montage der Drucktastschalter wesentlich vereinfacht. Außerdem erfüllt die Bedienvorrichtung 12 gleichzeitig eine Designfunktion, wenn die Deckschichten 26 entsprechend gestaltet sind.

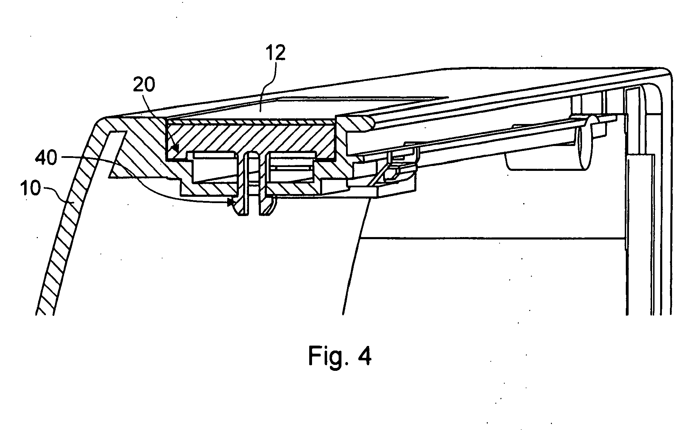

Zur Fixierung der vorgefertigten Bedienvorrichtung 12 in der Bedienblende 10 kann eine dritte Klebeschicht 30 auf der dem Benutzer abgewaridten Seite der Bedienvorrichtung 12 vorgesehen sein (siehe Fig. 2). Alternativ oder zusätzlich ist das Trägerelement 20 mit wenigstens einer Rastvorrichtung 40 ausgebildet, mit weicher die Bedienvorrichtung 12_ in entsprechende Rastausnehmungen der Bedienblende 10 eingerastet werden kann, wie in Fig. 4 dargestellt.

Wie in Fig. 1 und 2 dargestellt, verfügt die Bedienvorrichtung 12 neben den beiden Eingabebereichen 14, in denen jeweils eine Piezofolie 24 zur Ausbildung der mehreren Drucktastschalter angeordnet ist, auch über einen Anzeigebereich 16. In diesem Anzeigebereich 16 ist an der dem Benutzer abgewandten Seite des Trägerelements 20 ein Anzeigeelement 32 in der Form eines Displays mit einer 7-Segmentanzeige angeordnet und auf der dem Benutzer zugewandten Seite des Trägerelements 20 ist eine bedruckte Anzeigenabdeckung 34 aus Kunststoff (beispielsweise PMMA) auf das Trägerelement 20 geklebt. Das Anzeigeelement 32 kann wahlweise auch nur einzelne Leuchtdioden aüfweisen.

In dem Beispiel enthält die Bedienvorrichtung 12 zwei Eingabebereiche 14 mit Drucktastschaltem und einen Anzeigebereich 16, die vorliegende Erfindung ist aber nicht nur auf diese Ausführungsform beschränkt. Beispielsweise kann die Bedienvorrichtung 12 auch nur einen Eingabebereich 14 oder mehr als zwei Eingabebereiche 14 enthalten, mehrere Eingabebereiche 14 können wahlweise nebeneinander und/oder hintereinander angeordnet sein. Auf den Anzeigebereich 16 kann auch verzichtet werden oder es können zwei oder mehr Anzeigebereiche 16 in der Bedienvorrichtung 12 vorhanden sein. Auch ist die Anzahl der Drucktastschalter in einem Eingabebereich 14 bzw. die Anzahl der Sensorfelder 23 auf einer Piezofolie 24 nicht speziell eingeschränkt. Ferner muss nicht jedem Sensorfeld 23 der Piezofolie 24 notwendigerweise ein Drucktastschalter zugeordnet sein, sodass zum Beispiel für mehrere Arten und Modelle eines Haushaltsgeräts mit unterschiedlichen Eingabebereichen 14 jeweils die gleichen Piezofolien 24 verwendet werden können.

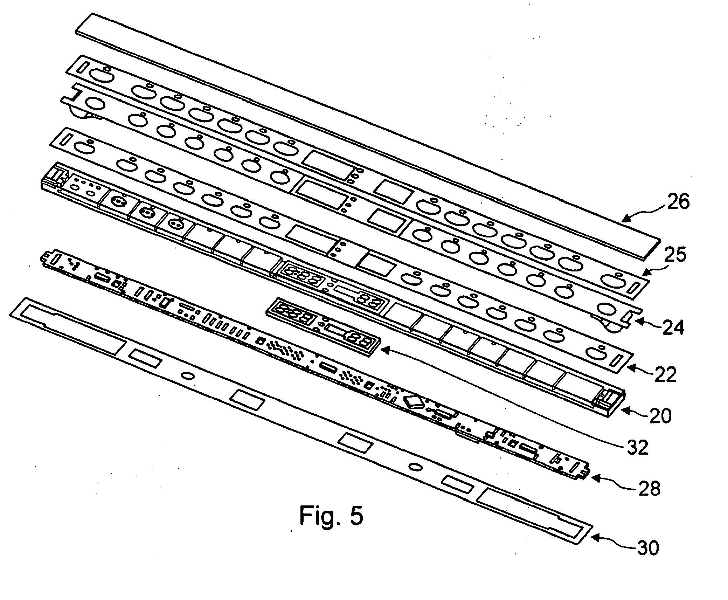

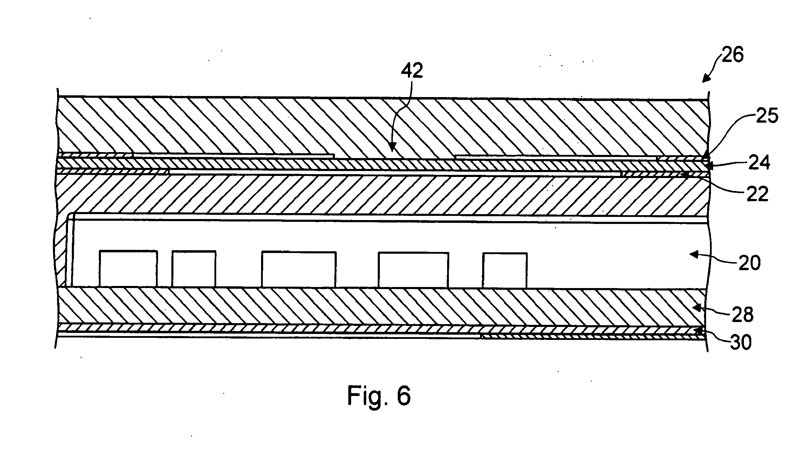

Bezug nehmend auf Fig. 5 und 6 wird nun eine Bedienvorrichtung 12 gesäß einem Ausführungsbeispiel erläutert. Dabei sind gleiche bzw. entsprechende Komponenten jeweils mit den gleichen Bezugsziffern wie im obigen Beispiel gekennzeichnet.

Der Aufbau der Bedienvorrichtung 12 des Ausführungsbeispiels umfasst analog zum obigen Beispiel ebenfalls ein Trägerelement 20, eine Piezofolie 24 für die beiden Eingabebereiche 14, eine Deckschicht 26, eine in das Trägerelement 20 eingesetzte Leiterplatte 28 und ein Anzeigenelement 32. Als Befestigungselement der Bedienvorrichtung 12 in der Bedienblende 10 ist eine dritte Klebeschicht 30 vorgesehen und zur Verbindung der Piezofolie 24 mit dem Trägerelement 20 ist eine erste Klebeschicht 22 zur weichen Flächenverbindung zwischen den beiden Komponenten vorgegehen.

Das Ausführungsbeispiel von Fig. 5 und 6 unterscheidet sich von dem oben beschriebenen Beispiel darin, dass die zweite Klebeschicht 25 keine steife und unnachgiebige Flächenverbindung zwischen der Deckschicht 26 und der Piezofolie 24 bildet, solidem eine weiche und nachgiebige Flächenverbindung. Hierdurch können in vorteilhafter Weise unterschiedliche Wärmeausdehnungen der Deckschicht 26 und der Piezofolie 24, die durch deren unterschiedliche Materialien bedingt sind, kompensiert oder zumindest deutlich vermindert werden, so dass zwischen den beiden Komponenten keine wärmeabhängigen Verspannungen und Verformungen entstehen.

Die Nachgiebigkeit der zweiten Klebeschicht 25 vermindert aber die Übertragung der kleinen Betätigungsweg von der Deckschicht 26 auf die Piezofolie 24 und wirkt so der eigentlichen Schaltfunktion der Drucktastschalter entgegen. Aus diesem Grund ist im Bereich eines Sensorfeldes 23 jeweils ein Klrafiübertragungselement 42 zwischen der Piezofolie 24 und der Deckschicht 26 angeordnet, das in einer entsprechenden-Aussparung der zweiten Klebschicht 25 plaziert ist und die Druckkräfte von der als Betätigungsfläche dienenden Deckschicht 26 auf die druckempfindliche Piezofolie 24 Oberträgt. Das Kraftübertragungselement 42 stellt trotz der weichen Verbindung zwischen der Deckschicht 26 und der Piezofolie 24 die für eine einwandfreie Funktion der Drucktastschalter der Bedienvorrichtung 12 erforderliche unachgiebige Verbindung her. Es ist zum Beispiel als ein mit der Deckschicht 26 verbundener (Drucken, Kleben, Spritzen, usw.) Stößel, Noppen oder dergleichen ausgebildet.

Die übrigen Merkmale und Vorteile sind gleich jenen des obigen Beispiels und auf ihre nochmalige Beschreibung wird verzichtet.

### BEZUGSZIFFERNLISTE

- 10: Bedienblende
- 12: Bedienvorrichtung
- 14: Eingabebereich
- 16: Anzeigebereich
- 18: elektronische Steuerung
- 20: Trägerelement
- 22: erste Klebeschicht
- 23: Sensorfeld
- 24: Piezosensorfolie
- 25: zweite Klebeschicht
- 26: Deckschicht
- 28: Leiterplatte
- 30: dritte Klebeschicht
- 32: Anzeigeelement
- 34: Anzeigenabdeckung
- 36: Stecker
- 38: Verbindungskabel
- 40: Rastvorrichtung
- 42: Stößel

## Patentansprüche

1. Bedienvorrichtung (12) mit wenigstens einem Drucktastschalter, wobei die Bedienvorrichtung aufweist:
ein Trägerelement (20);
eine Piezofolie (24) mit wenigstens einem Sensorfeld (23) entsprechend dem wenigstens einen Drucktastschalter, wobei, die Piezofolie (24) mit dem Trägerelement (20) über eine erste Klebeschicht (22) verbunden ist;
eine der Benutzerseite zugewandte Deckschicht (26), die über eine zweite Klebeschicht (25) mit der Piezofolie (24) verbunden ist; und
wenigstens ein Befestigungselement (30, 40) zum Befestigen der Bedienvorrichtung (12) an einer Bedienblende (10),
**dadurch gekennzeichnet,**
**dass** die zweite Klebeschicht (25) zwischen der Piezofolie (24) und der
Deckschicht (26) weich ausgebildet ist; und
**dass** zwischen der Piezofolie (24) und der Deckschicht (26) im Bereich des wenigstens einen Sensorfeldes (23) innerhalb eines von der zweiten Klebeschicht (25) ausgesparten Raums ein Kraftübertragungselement (42) angeordnet ist.

2. Bedienvorrichtung nach Anspruch 1,
**dadurch gekennzeichnet,**
**dass** das Trägerelement (20) auf seiner der Piezofolie (24) abgewandten Seite eine Aussparung aufweist; und
**dass** die Bedienvorrichtung (12) ferner eine Leiterplatte (28) aufweist, die in die Aussparung des Trägerelements (20) eingesetzt ist.

3. Bedienvorrichtung nach Anspruch 2,
**dadurch gekennzeichnet,**
**dass** die Leiterplatte (28) in der Aussparung des Trägerelements (20) im Wesentlichen vollständig aufgenommen ist.

4. Bedienvorrichtung nach einem der vorherigen Ansprüche,
**dadurch gekennzeichnet,**
**dass** das Kraftübertragungsetement (42) ein mit der Deckschicht (26) verbundener Stößel ist.

5. Bedienvorrichtung nach einem der vorherigen Ansprüche,
**dadurch gekennzeichnet,**
**dass** das wenigstens eine Befestigungselement eine dritte Klebeschicht (30) enthält.

6. Bedienvorrichtung nach einem der vorherigen Ansprüche
**dadurch gekennzeichnet,**
**dass** das wenigstens eine Befestigungselement eine Rastvorrichtung (40) enthält.

7. Bedienvorrichtung nach einem der vorherigen Ansprüche,
**dadurch gekennzeichnet,**
**dass** die Bedienvorrichtung (12) ferner wenigstens ein Anzeigeelement (32) aufweist, das ebenfalls in dem Trägerelement (20) integriert ist.

8. elektronisches Haushaltsgerät mit einer Bedienblende (10) und einer in die Bedienblende eingesetzten Bedienvorrichtung (12) nach einem der Ansprüche 1 bis 7.

## Claims

1. Control apparatus (12) having at least one pushbutton switch, with the control apparatus having:
a mount element (20);
a piezo-film (24) having at least one sensor field (23) corresponding to the at least one pushbutton switch, with the piezo-film (24) being connected to the mount element (20) via a first adhesive layer (22);
a cover layer (26), which faces the user side and is connected via a second adhesive layer (25) to the piezo-film (24); and
at least one attachment element (30, 40) for attachment of the control apparatus (12) to a control panel (10), **characterized**
**in that** the second adhesive layer (25) between the piezo-film (24) and the cover layer (26) is soft; and
**in that** a force transmission element (42) is arranged within an area cut out from the second adhesive layer (25) between the piezo-film (24) and the cover layer (26), in the area of the at least one sensor field (23).

2. Control apparatus according to Claim 1,
**characterized**
**in that** the mount element (20) has a cutout on its side facing away from the piezo-film (24); and
**in that** the control apparatus (12) also has a printed circuit board (28), which is inserted into the cutout in the mount element (20).

3. Control apparatus according to Claim 2,
**characterized**
**in that** the printed circuit board (28) is held essentially completely in the cutout in the mount element (20).

4. Control apparatus according to one of the preceding claims
**characterized**
**in that** the force transmission element (42) is a plunger which is connected to the cover layer (26).

5. Control apparatus according to one of the preceding claims,
**characterized**
**in that** the at least one attachment element contains a third adhesive layer (30).

6. Control apparatus according to one of the preceding claims,
**characterized**
**in that** the at least one attachment element contains a latching apparatus (40).

7. Control apparatus according to one of the preceding claims,
**characterized**
**in that** the control apparatus (12) also has at least one display element (32), which is likewise integrated in the mount element (20).

8. Electronic domestic appliance having a control panel (10) and having a control apparatus (12), which is inserted into the control panel, according to one of Claims 1 to 7.

## Revendications

1. Dispositif de commande (12) doté d'au moins un interrupteur à touche, le dispositif de commande comportant
un élément de support (20) ;
un film piézoélectrique (24) avec au moins un champ de capteur (23) correspondant à au moins un interrupteur à touche, le film piézoélectrique (24) étant accolé à l'élément support (20) par l'intermédiaire d'une première couche de colle (22) ;
une couche de finition (26) orientée du côté de l'utilisateur, accolée au film piézoélectrique (24) par l'intermédiaire d'une deuxième couche de colle (25) ;
et au moins un élément de fixation (30, 40) pour fixer le dispositif de commande (12) à un bandeau de commande (10),
**caractérisé en ce que** la deuxième couche de colle (25) est formée de manière souple entre le film piézoélectrique (24) et la couche de finition (26) ;
et **en ce qu'**un élément de transfert de la force (42) est disposé entre le film piézoélectrique (24) et la couche de finition (26) dans le domaine d'au moins un champ de capteur (23) à l'intérieur d'un espace évidé de la deuxième couche de colle (25).

2. Dispositif de commande selon la revendication 1,
**caractérisé en ce que** l'élément support (20) comporte un évidement sur sa face éloignée du film piézoélectrique (24) ;
et **en ce que** le dispositif de commande (12) comporte de plus un circuit imprimé (28) inséré dans l'évidement de l'élément support (20).

3. Dispositif de commande selon la revendication 2,
**caractérisé en ce que** le circuit imprimé (28) est pour l'essentiel totalement intégré dans l'évidement de l'élément support (20).

4. Dispositif de commande selon une des revendications précédentes,
**caractérisé en ce que** l'élément de transfert de la force (42) est un poussoir relié à la couche de finition (26).

5. Dispositif de commande selon une des revendications précédentes,
**caractérisé en ce qu'**au moins un élément de fixation contient une troisième couche de colle (30).

6. Dispositif de commande selon une des revendications précédentes,
**caractérisé en ce qu'**au moins un élément de fixation contient un dispositif d'accrochage (40).

7. Dispositif de commande selon une des revendications précédentes,
**caractérisé en ce que** le dispositif de commande (12) comporte de plus au moins un élément d'affichage (32) également intégré dans l'évidement de l'élément support (20).

8. Appareil ménager électronique avec un bandeau de commande (10) et un dispositif de commande (12) inséré dans le bandeau de commande selon une des revendications 1 à 7.
